# EUROPEAN PATENT SPECIFICATION

(11) **EP 3 993 587 B1**
(45) Date of publication and mention of the grant of the patent: **04.10.2023**
(21) Application number: 21192686.0
(22) Date of filing: 23.08.2021
(51) Int. Cl.: H05K 7/20, F28F 13/00

(54) **WATER-COOLER HEAT DISSIPATION DEVICE AND ELECTRICAL DEVICE**
WÄRMEABLEITENDE VORRICHTUNG EINES WASSERKÜHLERS UND ELEKTRISCHE VORRICHTUNG
DISPOSITIF DE DISSIPATION DE CHALEUR DE REFROIDISSEUR D'EAU ET DISPOSITIF ÉLECTRIQUE

(30) Priority: 02.11.2020 CN 202011204606
(43) Date of publication of application: 04.05.2022
(73) Proprietor: Sungrow Power Supply Co., Ltd., Hefei, Anhui 230088 (CN)
(72) Inventor: Li, Xuan, Hefei, Anhui, 230088 (CN); Zhou, Jie, Hefei, Anhui, 230088 (CN)
(74) Representative: Zacco Norway AS

(56) References cited:
- EP-A1- 3 217 137
- EP-B1- 0 717 440
- CN-A- 108 302 970
- US-A1- 2015 008 574

## Description

### FIELD

The present application relates to the technical field of heat dissipation of electrical devices, and in particular to a water-cooler heat dissipation device. Another object of the present application is to provide an electrical device including the above water-cooler heat dissipation device.

### BACKGROUND

For heat dissipation mounted with a heating device, natural cooling and air cooling are generally used to dissipate heat. However, for an electrical device with high heat flux density, air cooling can no longer meet the heat dissipation requirement, and a liquid cooling method with a relatively great heat exchange capacity is required for heat dissipation.

For example, the liquid cooling method is used by an electric vehicle controller, and a water-cooled plate of the electric vehicle controller is generally designed with different sizes of fins in a cavity to form different water passages, so that an area of a tooth is as large as possible and a heat dissipation area of the water-cooled plate is increased. A conventional water-cooled heat dissipation device is formed by die-casting. However, due to the limitation of the die-casting molding process, the heat dissipation fins cannot be thinned and the tooth spacing is reduced, which also limits the heat dissipation area of the tooth, and results in poor heat dissipation efficiency of the water-cooled heat dissipation device.

Therefore, those skilled in the art have a strong desire is how to improve the heat dissipation efficiency of the water-cooled heat dissipation device.
US 2015/008574 A1 discloses a semiconductor device including a semiconductor module and a cooler for cooling the semiconductor module. The cooler has a heat radiating substrate, a plurality of fins fixed to the heat radiating substrate, and a case which accommodates the fins. The heat radiating substrate and the fins are integrated. In another embodiment, the cross-sectional shape of the heat radiating substrate which constitutes the cooler has an L-shaped form and therefore differs from the heat radiating substrate of the semiconductor device, the upper ends of the side walls of the case and the end portions of the heat radiating substrate are bonded in a liquid-tight fashion along the side walls.

CN 108 302 970 A discloses a cold plate, including a cover, a base and a three-dimensional structure. The base has a side wall, and the side wall extends from the base toward the cover body. The cover body and the base together form a chamber, which allows the working fluid to pass through and take away the heat energy transferred from the heating source. The three-dimensional structure is arranged in the chamber, one side of the three-dimensional structure is a plane which can be attached to the inner side of the base, and the other side of the three-dimensional structure is fins.

EP 0 717 440 B1 and EP 3 217 137 A1 disclose heat dissipation devices having interlocking cooling fins extending from opposing surfaces.

### SUMMARY

An object according to the present application is to provide a water-cooled heat dissipation device, so as to improve the heat dissipation efficiency of the water-cooled heat dissipation device. Another object according to the present application is to provide an electrical device including the above water-cooled heat dissipation device.

In order to achieve the above objects, a water-cooled heat dissipation device is provided according to the present application, which includes a first water-cooled plate and a sealing plate; where the first water-cooled plate includes a first water-cooled substrate and multiple first heat dissipation fins arranged on the first water-cooled substrate, the sealing plate includes a sealing plate substrate and multiple second heat dissipation fins arranged on the sealing plate substrate and each arranged between two first heat dissipation fins, and the first water-cooled substrate is hermetically matched with the sealing plate substrate to form a water-cooled cavity for accommodating the multiple first heat dissipation fins and the multiple second heat dissipation fins; the water-cooled heat dissipation device further includes a first heat-conducting component with one end connected to the first water-cooled substrate and the other end connected to the second heat dissipation fins.

Preferably, the first heat-conducting component includes a first elastic compression member, a first end of the first elastic compression member is connected to the first water-cooled substrate, and a second end of the first elastic compression member is connected to free ends of the second heat dissipation fins.

Preferably, the first heat-conducting component includes a first heat-conducting plate connected at the second end of the first elastic compression member, and the first elastic compression member abuts against the second heat dissipation fins through the first heat-conducting plate.

Preferably, the first elastic compression member is a spring, and the second end of the first elastic compression member is a heat-conducting plane which abuts against the first heat dissipation fins.

Preferably, multiple first elastic compression members are arranged between two adjacent first heat dissipation fins.

Preferably, the first heat-conducting component is first heat-conducting glue filled at a groove bottom of the two adjacent first heat dissipation fins.

Preferably, the sealing plate is a second water-cooled plate, and the water-cooled heat dissipation device further includes a second heat-conducting component with one end connected to the first heat dissipation fins and the other end connected to the sealing plate substrate.

Preferably, the second heat-conducting component includes a second elastic compression member, a first end of the second elastic compression member is connected to the sealing plate substrate, and a second end of the second elastic compression member is connected to free ends of the first heat dissipation fins.

Preferably, the second heat-conducting component includes a second heat-conducting plate connected at the second end of the second elastic compression member, and the second elastic compression member abuts against the first heat dissipation fins through the second heat-conducting plate.

Preferably, the second elastic compression member is a spring, and the second end of the second elastic compression member is a heat-conducting plane which abuts against the first heat dissipation fins.

Preferably, multiple second elastic compression members are arranged between two adjacent second heat dissipation fins.

Preferably, the second heat-conducting component is second heat-conducting glue filled at a groove bottom of the two adjacent second heat dissipation fins.

Preferably, spacing between the two adjacent first heat dissipation fins is equal to spacing between the two adjacent second heat dissipation fins.

Preferably, the multiple first heat dissipation fins and the multiple second heat dissipation fins are arranged alternately in sequence.

Preferably, the first water-cooled plate and/or the sealing plate have/has an integrally formed structure.

Preferably, the first water-cooled plate and/or the sealing plate have/has a die-casting structure.

An electrical device includes a water-cooled heat dissipation device and a heat generating module arranged on the water-cooled heat dissipation device, and the water-cooled heat dissipation device is the water-cooled heat dissipation device according to any one of the above.

Preferably, the electrical device is an electric vehicle controller.

In the above technical solution, the water-cooled heat dissipation device according to the present application includes the first water-cooled plate and the sealing plate. The first water-cooled plate includes a first water-cooled substrate and the first heat dissipation fins arranged on the first water-cooled substrate. The sealing plate includes the sealing plate substrate and the second heat dissipation fins arranged on the sealing plate substrate and each arranged between two first heat dissipation fins, and the first water-cooled substrate is hermetically matched with the sealing plate substrate to form the water-cooled cavity for accommodating the first heat dissipation fins and the second heat dissipation fins.

As can be seen from the above description, in the water-cooled heat dissipation device according to the present application, the second heat dissipation fins are provided on the sealing plate substrate, so as to increases the overall heat dissipation area of the water-cooled heat dissipation device, thereby improving the heat dissipation efficiency of the water-cooled heat dissipation device.

### BRIEF DESCRIPTION OF THE DRAWINGS

For more clearly illustrating embodiments of the present application or the technical solutions in the conventional technology, drawings to be used in the description of the embodiments or the conventional technology will be briefly described hereinafter. Apparently, the drawings in the following description are only some embodiments of the present application. For those skilled in the art, other drawings may be obtained based on the provided drawings without any creative work.
Figure 1 is a three-dimensional structural sectional diagram of a water-cooled heat dissipation device according to an embodiment of the present application;
Figure 2 is a three-dimensional structural diagram of an electrical device according to an embodiment of the present application;
Figure 3 is a schematic structural diagram of a first water-cooled plate according to an embodiment of the present application;
Figure 4 is a schematic structural diagram of a sealing plate according to an embodiment of the present application;
Figure 5 is a partial schematic structural diagram of a first water-cooled heat dissipation device according to an embodiment of the present application;
Figure 6 is a three-dimensional structural diagram of the first water-cooled heat dissipation device in FIG. 5;
Figure is a partial schematic structural diagram of a second water-cooled heat dissipation device according to an embodiment of the present application;
Figure 8 is a partial schematic structural diagram of a third water-cooled heat dissipation device according to an embodiment of the present application;
Figure 9 is a partial schematic structural diagram of a fourth water-cooled heat dissipation device according to an embodiment of the present application;
Figure 10 is a partial schematic structural diagram of a fifth water-cooled heat dissipation device according to an embodiment of the present application.

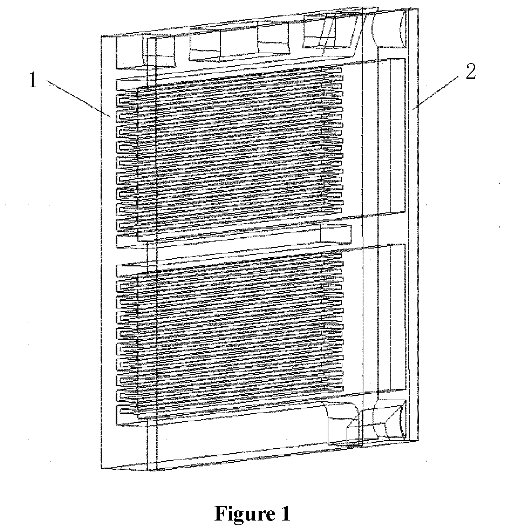

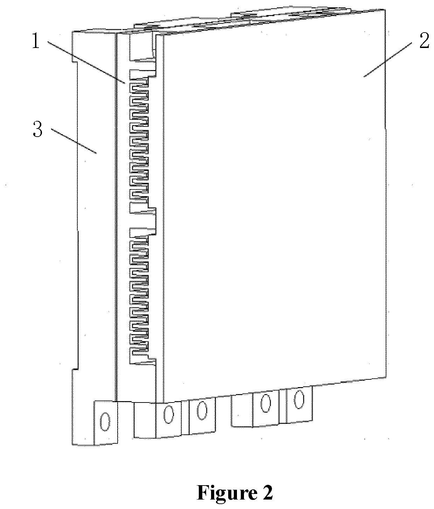

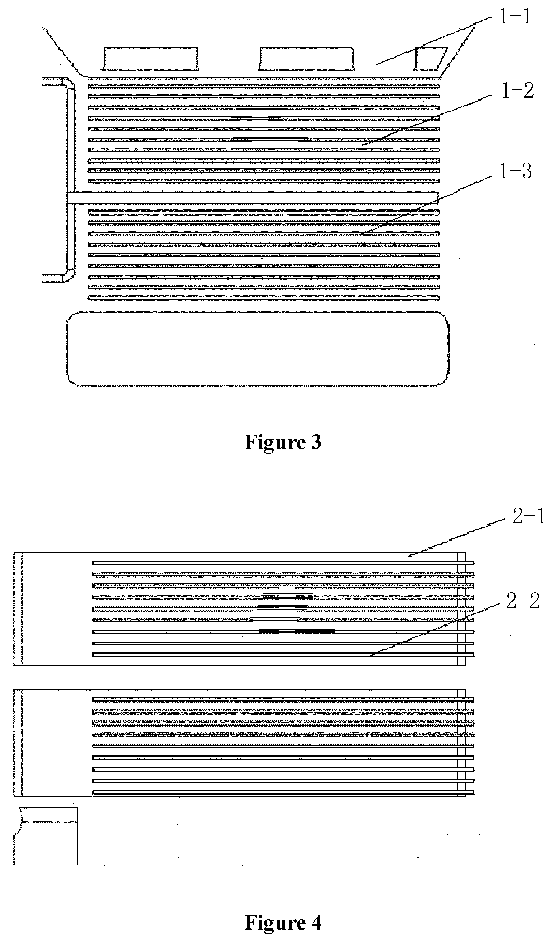

### Reference numerals in Figures 1 to 10:

| | | | |
|---|---|---|---|
| 1 | first water-cooled plate; | 1-1 | first water-cooled substrate; |
| 1-2 | water cooled cavity; | 1-3 | first heat dissipation fin; |
| 2 | sealing plate; | 2-1 | sealing plate substrate; |
| 2-2 | second heat dissipation fin; | 3 | heat generation module; |
| 4 | first elastic compression member; | 5 | first heat-conducting glue; |
| 6 | second heat-conducting glue; | 7 | second elastic compression member. |

### DETAILED DESCRIPTION OF THE EMBODIMENTS

A core of the present application is to provide a water-cooled heat dissipation device, so as to improve the heat dissipation efficiency of the water-cooled heat dissipation device. Another object according to the present application is to provide an electrical device including the above water-cooled heat dissipation device.

In order to enable those skilled in the art to better understand the technical solutions of the present application, the present application will be further described in detail below with reference to the drawings and embodiments.

References are made to Figure 1 to 10.

In a specific embodiment, the water-cooled heat dissipation device according to an embodiment of the present application includes a first water-cooled plate 1 and a sealing plate 2. Specifically, a water inlet and a water outlet may be arranged at corresponding positions of the first water-cooled plate 1 and the sealing plate 2 as required, which is not limited in this application.

The first water-cooled plate 1 includes a first water-cooled substrate 1-1 and multiple first heat dissipation fins 1-3 arranged on the first water-cooled substrate 1-1. Specifically, the first heat dissipation fins 1-3 may have a flat plate structure or a curved structure or the like. The first heat dissipation fins 1-3 may be mounted on the first water-cooled substrate 1-1 by gluing, welding or the like. Preferably, any two adjacent first heat dissipation fins 1-3 have a same spacing.

The sealing plate 2 includes a sealing plate substrate 2-1 and multiple second heat dissipation fins 2-2 arranged on the sealing plate substrate 2-1 and each arranged between two first heat dissipation fins 1-3, and one second heat dissipation fin 2-2 is provided between the two first heat dissipation fins 1-3. Specifically, the second heat dissipation fins 2-2 may have a flat plate structure or a curved structure or the like. The second heat dissipation fins 2-2 may be mounted on the first water-cooled substrate 1-1 by gluing, welding or the like. Preferably, any two adjacent second heat dissipation fins 2-2 have a same spacing.

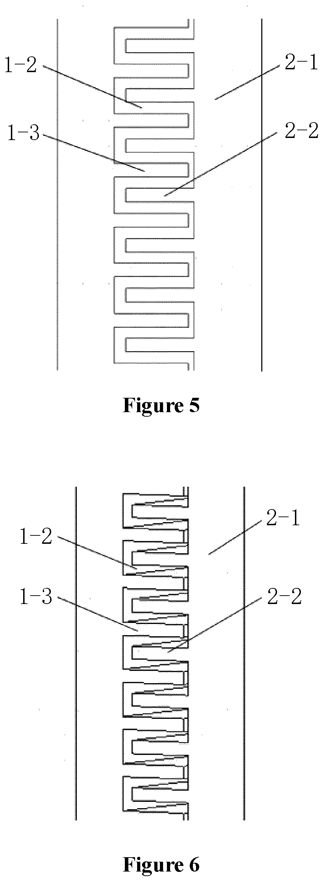

As shown in Figure 5, preferably, the first heat dissipation fins 1-3 and the second heat dissipation fins 2-2 are arranged alternately in sequence. That is, one second heat dissipation fin 2-2 is provided between the two adjacent first heat dissipation fins 1-3.

In order to improve assembly efficiency, preferably, the first water-cooled plate 1 and/or the sealing plate 2 have/has an integrally formed structure. Specifically, the first water-cooled plate 1 and/or the sealing plate 2 have/has a die-casting structure. The first water-cooled plate 1 and the sealing plate 2 have a die-casting structure, which may both be an aluminum member.

Specifically, in order to improve the uniformity of heat dissipation, preferably, spacing between the two adjacent first heat dissipation fins 1-3 is equal to spacing between the two adjacent second heat dissipation fins 2-2.

The first water-cooled plate 1 and the sealing plate 2 are formed by die-casting, so that the problem of water-cooled heat dissipation with large loss is solved at low cost, which effectively enhances the heat dissipation capacity of the water-cooled system, reduces the cost, and has strong practicability.

The first water-cooled substrate 1-1 is hermetically matched with the sealing plate substrate 2-1 to form a water-cooled cavity 1-2 for accommodating the first heat dissipation fins 1-3 and the second heat dissipation fins 2-2. Specifically, the water-cooled cavity 1-2 may be provided in a groove structure on the first water-cooled substrate 1-1.

Specifically, a heat generation module 3 is attached to an outside of the first water-cooled substrate 1-1, and the heat of the heat generation module 3 is taken away by the water flowing in the water-cooled cavity 1-2. Specifically, the first heat dissipation fins 1-3 are formed by die-casting on the first water-cooled substrate 1-1, and the corresponding second heat dissipation fins 2-2 are formed by die-casting on the sealing plate 2, so that the first water-cooled plate 1 and the sealing plate 2 may be mounted in a staggered position together to form the water-cooled cavity 1-2. On this basis, a heat dissipation area of the fins may be doubled, thereby effectively improving the heat dissipation efficiency of the water-cooled heat dissipation device.

Due to the assembly and processing errors of the first water-cooled plate 1 and the sealing plate 2, the second heat dissipation fins 2-2 may not be possible to closely fit with the first water-cooled substrate 1-1. Preferably, the water-cooled heat dissipation device further includes a first heat-conducting component with one end connected to the first water-cooled substrate 1-1 and the other end connected to the second heat dissipation fins 2-2. In order to facilitate assembly and disassembly, preferably, one of the first water-cooled substrate 1-1 and the second heat dissipation fin 2-2 is fixedly connected to the first heat-conducting component, and the other one of the first water-cooled substrate 1-1 and the second heat dissipation fin 2-2 abuts against the first heat-conducting component. Specifically, the first heat-conducting component is made of material with relatively high thermal conductivity.

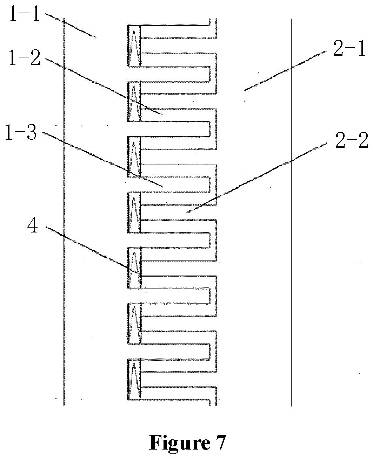

As shown in Figure 7, the first heat-conducting component includes a first elastic compression member 4, a first end of the first elastic compression member 4 is connected to the first water-cooled substrate 1-1, and a second end of the first elastic compression member 4 is connected to free ends of the second heat dissipation fins 2-2.

Specifically, the first elastic compression member 4 may be a spring. In order to improve the thermal conduction efficiency, preferably, the second end of the first elastic compression member 4 is a heat-conducting plane which abuts against the second heat dissipation fins 2-2. That is, the spring type may be a flat spring so as to increase a contact area between the second heat dissipation fins 2-2 and the first water-cooled substrate 1-1.

Preferably, the first heat-conducting component includes a first heat-conducting plate connected at the second end of the first elastic compression member 4, and the first elastic compression member 4 abuts against the second heat dissipation fins 2-2 through the first heat-conducting plate. By providing the first heat-conducting plate, on one hand, the heat-conducting area is increased, and on the other hand, the first heat-conducting component is in stable contact with the second heat dissipation fin 2-2.

Specifically, the first elastic compression member 4 may be mounted by welding, gluing, crimping, interference fit, etc., and the spring material may be made of metal with a relatively high thermal conductivity, which is able to enhance the heat dissipation effect of the second heat dissipation fins 2-2.

In order to further improve the thermal conduction effect, preferably, multiple first elastic compression members 4 are arranged between the two adjacent first heat dissipation fins 1-3. Specifically, any two adjacent first elastic compression members 4 in the same row have a same spacing.

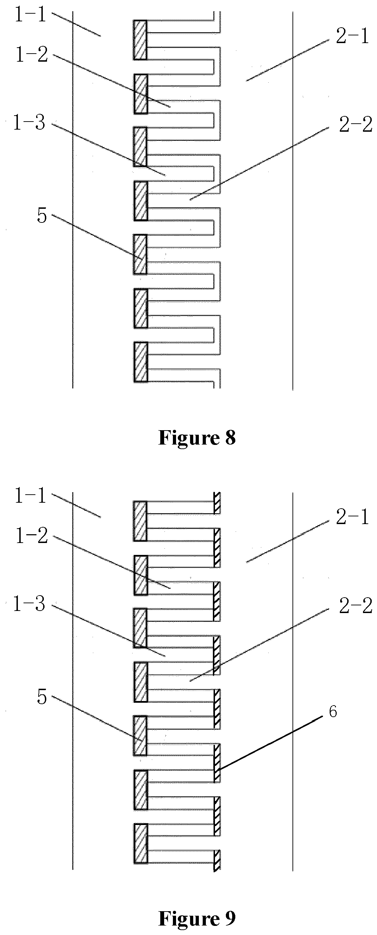

As shown in Figure 8, in another embodiment, the first heat-conducting component is first heat-conducting glue 5 filled at a groove bottom of the two adjacent first heat dissipation fins 1-3. Specifically, the first heat-conducting glue 5 is heat-conducting glue with a relatively high thermal conductivity. Specifically, the second heat dissipation fin 2-2 may be connected to the first water-cooled substrate 1-1 through the first heat-conducting glue 5.

In a case that the heat generation modules 3 are mounted on two sides of the water-cooled heat dissipation device, preferably, the sealing plate 2 is used as a second water-cooled plate, the sealing plate substrate 2-1 is used as a second water-cooled substrate, and the water-cooled heat dissipation device further includes a second heat-conducting component with one end connected to the first heat dissipation fin 1-3 and the other end connected to the sealing plate substrate 2-1. By providing the second heat-conducting component, the heat of the heat generation module 3 on the second water-cooled plate may be taken out as soon as possible.

In order to facilitate assembly and disassembly, preferably, one of the sealing plate substrate 2-1 and the first heat dissipation fin 1-3 is fixedly connected to the second heat-conducting component, and the other one of the sealing plate substrate 2-1 and the first heat dissipation fin 1-3 abuts against the second heat-conducting component. Specifically, the second heat-conducting component is made of material with relatively high thermal conductivity.

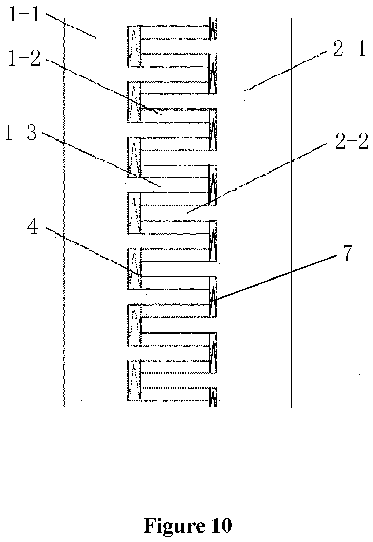

As shown in Figure 10, specifically, the second heat-conducting component includes a second elastic compression member 7, a first end of the second elastic compression member 7 is connected to the sealing plate substrate 2-1, and a second end of the second elastic compression member 7 is connected to free ends of the first heat dissipation fins 1-3.

Specifically, the second elastic compression member 7 may be a spring. In order to improve the thermal conduction efficiency, preferably, the second end of the second elastic compression member 7 is a heat-conducting plane which abuts against the first heat dissipation fins 1-3. That is, the spring type may be a flat spring so as to increase a contact area between the first heat dissipation fins 1-3 and the sealing plate substrate 2-1.

Specifically, the second elastic compression member 7 may be mounted by welding, gluing, crimping, interference fit, etc., and the spring material may be made of metal with a relatively high thermal conductivity, which is able to enhance the heat dissipation effect of the first heat dissipation fins 1-3.

In an embodiment, the second heat-conducting component includes a second heat-conducting plate connected at the second end of the second elastic compression member 7, and the second elastic compression member 7 abuts against the first heat dissipation fin 1-3 through the second heat-conducting plate. By providing the second heat-conducting plate, on one hand, the heat-conducting area is increased, and on the other hand, the second heat-conducting component is in stable contact with the first heat dissipation fins 1-3.

In order to further improve the thermal conduction effect, preferably, multiple second elastic compression members 7 are arranged between the two adjacent second heat dissipation fins. Specifically, any two adjacent second elastic compression members 7 in the same row have a same spacing.

As shown in Figure 9. In another embodiment, the second heat-conducting component is second heat-conducting glue 6 filled at a groove bottom of the two adjacent second heat dissipation fins 2-2. Specifically, the second heat-conducting glue 6 is heat-conducting glue with a relatively high thermal conductivity. Specifically, the first heat dissipation fins 1-3 may be connected to the sealing plate substrate 2-1 through the second heat-conducting glue 6.

An electrical device according to the present application includes a water-cooled heat dissipation device and a heat generation module 3 arranged on the water-cooled heat dissipation device, and the water-cooled heat dissipation device is the water-cooled heat dissipation device according to any one of the above. Specifically, the electrical device is an electric vehicle controller, or the electrical device may be other electrical device structures. The specific structure of the water-cooled heat dissipation device has been described above. And this application includes the above water-cooled heat dissipation device, which also has the above technical effects.

The above embodiments are described in a progressive manner. Each of the embodiments is mainly focused on describing its differences from other embodiments, and reference may be made among these embodiments with respect to the same or similar parts.

The above illustration of the disclosed embodiments can enable those skilled in the art to implement or use the present application. Various modifications to the embodiments are apparent to the person skilled in the art, and the general principle herein can be implemented in other embodiments without departing from the scope of the present application. Therefore, the present application is not limited to the embodiments described herein, but should be in accordance with the broadest scope consistent with the principle and novel features disclosed herein as long as within the limits as defined by the appended claims.

## Claims

1. A water-cooled heat dissipation device, comprising a first water-cooled plate (1) and a sealing plate (2); wherein
the first water-cooled plate (1) comprises a first water-cooled substrate (1-1) and a plurality of first heat dissipation fins (1-3) arranged on the first water-cooled substrate (1-1); and
the sealing plate (2) comprises a sealing plate substrate (2-1) and a plurality of second heat dissipation fins (2-2) arranged on the sealing plate substrate (2-1) and each arranged between two of the plurality of first heat dissipation fins (1-3), and the first water-cooled substrate (1-1) is hermetically matched with the sealing plate substrate (2-2) to form a water-cooled cavity (1-2) for accommodating the plurality of first heat dissipation fins (1-3) and the plurality of second heat dissipation fins (2-2); **characterized in that**,
the water-cooled heat dissipation device further comprises a first heat-conducting component with one end connected to the first water-cooled substrate (1-1) and the other end connected to the second heat dissipation fins (2-2).

2. The water-cooled heat dissipation device according to claim 1, wherein the first heat-conducting component comprises a first elastic compression member (4), a first end of the first elastic compression member (4) is connected to the first water-cooled substrate (1-1), and a second end of the first elastic compression member (4) is connected to free ends of the second heat dissipation fins (2-2).

3. The water-cooled heat dissipation device according to claim 2, wherein the first heat-conducting component comprises a first heat-conducting plate connected at the second end of the first elastic compression member (4), and the first elastic compression member (4) abuts against the second heat dissipation fins (2-2) through the first heat-conducting plate.

4. The water-cooled heat dissipation device according to claim 2, wherein the first elastic compression member (4) is a spring, and the second end of the first elastic compression member (4) is a heat-conducting plane which abuts against the first heat dissipation fins (1-3).

5. The water-cooled heat dissipation device according to claim 2, wherein a plurality of first elastic compression members (4) are arranged between two adjacent first heat dissipation fins (1-3).

6. The water-cooled heat dissipation device according to claim 1, wherein the first heat-conducting component is first heat-conducting glue (5) filled at a groove bottom of the two adjacent first heat dissipation fins (1-3).

7. The water-cooled heat dissipation device according to claim 1, wherein the sealing plate (2) is a second water-cooled plate, and the water-cooled heat dissipation device comprises a second heat-conducting component with one end connected to the first heat dissipation fins (1-3) and the other end connected with the sealing plate substrate (2-1).

8. The water-cooled heat dissipation device according to claim 7, wherein the second heat-conducting component comprises a second elastic compression member (7), a first end of the second elastic compression member (7) is connected to the sealing plate substrate (2-1), and a second end of the second elastic compression member (7) is connected to free ends of the first heat dissipation fins (1-3).

9. The water-cooled heat dissipation device according to claim 8, wherein the second heat-conducting component comprises a second heat-conducting plate connected at the second end of the second elastic compression member (7), and the second elastic compression member (7) abuts against the first heat dissipation fins (1-3) through the second heat-conducting plate.

10. The water-cooled heat dissipation device according to claim 9, wherein the second elastic compression member (7) is a spring, and the second end of the second elastic compression member (7) is a heat-conducting plane which abuts against the first heat dissipation fins (1-3).

11. The water-cooled heat dissipation device according to claim 8, wherein a plurality of second elastic compression members (7) are arranged between two adjacent second heat dissipation fins.

12. The water-cooled heat dissipation device according to claim 7, wherein the second heat-conducting component is second heat-conducting glue (6) filled at a groove bottom of the two adjacent second heat dissipation fins (2-2).

13. The water-cooled heat dissipation device according to claim 1, wherein spacing between the two adjacent first heat dissipation fins (1-3) is equal to spacing between the two adjacent second heat dissipation fins (2-2).

14. The water-cooled heat dissipation device according to claim 1, wherein the plurality of first heat dissipation fins (1-3) and the plurality of second heat dissipation fins (2-2) are arranged alternately in sequence.

15. The water-cooled heat dissipation device according to any one of claims 1 to 14, wherein the first water-cooled plate (1) and/or the sealing plate (2) have/has an integrally formed structure.

16. The water-cooled heat dissipation device according to claim 15, wherein the first water-cooled plate (1) and/or the sealing plate (2) have/has a die-casting structure.

17. An electrical device, comprising a water-cooled heat dissipation device and a heat generation module (3) arranged on the water-cooled heat dissipation device, wherein the water-cooled heat dissipation device is the water-cooled heat dissipation device according to any one of claims 1 to 16.

18. The electrical device according to claim 17, wherein the electrical device is an electric vehicle controller.

## Patentansprüche

1. Wassergekühlte wärmeableitende Vorrichtung, umfassend eine erste wassergekühlte Platte (1) und eine Dichtungsplatte (2); wobei
die erste wassergekühlte Platte (1) ein erstes wassergekühltes Substrat (1-1) und eine Vielzahl von ersten wärmeableitenden Rippen (1-3) angeordnet auf dem ersten wassergekühlten Substrat (1-1) umfasst; und
die Dichtungsplatte (2) ein Dichtungsplattensubstrat (2-1) und eine Vielzahl von zweiten wärmeableitenden Rippen (2-2) angeordnet auf dem Dichtungsplattensubstrat (2-1) und jeweils angeordnet zwischen zweien aus der Vielzahl von ersten wärmeableitenden Rippen (1-3) umfasst, und das erste wassergekühlte Substrat (1-1) hermetisch mit dem Dichtungsplattensubstrat (2-2) abgestimmt ist, um einen wassergekühlten Hohlraum (1-2) zum Aufnehmen der Vielzahl von ersten wärmeableitenden Rippen (1-3) und der Vielzahl von zweiten wärmeableitenden Rippen (2-2) zu bilden; **dadurch gekennzeichnet, dass**
die wassergekühlte wärmeableitende Vorrichtung ferner eine erste wärmeleitende Komponente umfasst, wobei ein Ende mit dem ersten wassergekühlten Substrat (1-1) verbunden ist und das andere Ende mit den zweiten wärmeableitenden Rippen (2-2) verbunden ist.

2. Wassergekühlte wärmeableitende Vorrichtung nach Anspruch 1, wobei die erste wärmeleitende Komponente ein erstes elastisches Kompressionselement (4) umfasst, wobei ein erstes Ende des ersten elastischen Kompressionselements (4) mit dem ersten wassergekühlten Substrat (1-1) verbunden ist und ein zweites Ende des ersten elastischen Kompressionselements (4) mit freien Enden der zweiten wärmeableitenden Rippen (2-2) verbunden ist.

3. Wassergekühlte wärmeableitende Vorrichtung nach Anspruch 2, wobei die erste wärmeleitende Komponente eine erste wärmeleitende Platte umfasst, die an dem zweiten Ende des ersten elastischen Kompressionselements (4) verbunden ist, und das erste elastische Kompressionselement (4) an den zweiten wärmeableitenden Rippen (2-2) durch die erste wärmeleitende Platte anliegt.

4. Wassergekühlte wärmeableitende Vorrichtung nach Anspruch 2, wobei das erste elastische Kompressionselement (4) eine Feder ist und das zweite Ende des ersten elastischen Kompressionselements (4) eine wärmeleitende Ebene ist, die an den ersten wärmeableitenden Rippen (1-3) anliegt.

5. Wassergekühlte wärmeableitende Vorrichtung nach Anspruch 2, wobei eine Vielzahl von ersten elastischen Kompressionselementen (4) zwischen zwei benachbarten ersten wärmeableitenden Rippen (1-3) angeordnet ist.

6. Wassergekühlte wärmeableitende Vorrichtung nach Anspruch 1, wobei die erste wärmeleitende Komponente ein erster wärmeleitender Klebstoff (5) ist, der an einem Rillenboden der zwei benachbarten ersten wärmeableitenden Rippen (1-3) eingefüllt ist.

7. Wassergekühlte wärmeableitende Vorrichtung nach Anspruch 1, wobei die Dichtungsplatte (2) eine zweite wassergekühlte Platte ist und die wassergekühlte wärmeableitende Vorrichtung eine zweite wärmeleitende Komponente umfasst, wobei ein Ende mit den ersten wärmeableitenden Rippen (1-3) verbunden ist und das andere Ende mit dem Dichtungsplattensubstrat (2-1) verbunden ist.

8. Wassergekühlte wärmeableitende Vorrichtung nach Anspruch 7, wobei die zweite wärmeleitende Komponente ein zweites elastisches Kompressionselement (7) umfasst, ein erstes Ende des zweiten elastischen Kompressionselements (7) mit dem Dichtungsplattensubstrat (2-1) verbunden ist und ein zweites Ende des zweiten elastischen Kompressionselements (7) mit freien Enden der ersten wärmeableitenden Rippen (1-3) verbunden ist.

9. Wassergekühlte wärmeableitende Vorrichtung nach Anspruch 8, wobei die zweite wärmeleitende Komponente eine zweite wärmeleitende Platte umfasst, die an dem zweiten Ende des zweiten elastischen Kompressionselements (7) verbunden ist, und das zweite elastische Kompressionselement (7) an den ersten wärmeableitenden Rippen (1-3) durch die zweite wärmeleitende Platte anliegt.

10. Wassergekühlte wärmeableitende Vorrichtung nach Anspruch 9, wobei das zweite elastische Kompressionselement (7) eine Feder ist und das zweite Ende des zweiten elastischen Kompressionselements (7) eine wärmeleitende Ebene ist, die an den ersten wärmeableitenden Rippen (1-3) anliegt.

11. Wassergekühlte wärmeableitende Vorrichtung nach Anspruch 8, wobei eine Vielzahl von zweiten elastischen Kompressionselementen (7) zwischen zwei benachbarten zweiten wärmeableitenden Rippen angeordnet ist.

12. Wassergekühlte wärmeableitende Vorrichtung nach Anspruch 7, wobei die zweite wärmeleitende Komponente zweiter wärmeleitender Klebstoff (6) ist, der an einem Rillenboden der zwei benachbarten zweiten wärmeableitenden Rippen (2-2) eingefüllt ist.

13. Wassergekühlte wärmeableitende Vorrichtung nach Anspruch 1, wobei Abstand zwischen den zwei benachbarten ersten wärmeableitenden Rippen (1-3) gleich Abstand zwischen den zwei benachbarten zweiten wärmeableitenden Rippen (2-2) ist.

14. Wassergekühlte wärmeableitende Vorrichtung nach Anspruch 1, wobei die Vielzahl von ersten wärmeableitenden Rippen (1-3) und die Vielzahl von zweiten wärmeableitenden Rippen (2-2) in abwechselnder Reihenfolge angeordnet sind.

15. Wassergekühlte wärmeableitende Vorrichtung nach einem der Ansprüche 1 bis 14, wobei die erste wassergekühlte Platte (1) und/oder die Dichtungsplatte (2) eine einstückig gebildete Struktur aufweist/aufweisen.

16. Wassergekühlte wärmeableitende Vorrichtung nach Anspruch 15, wobei die erste wassergekühlte Platte (1) und/oder die Dichtungsplatte (2) eine Druckgussstruktur aufweist/aufweisen.

17. Elektrische Vorrichtung, umfassend eine wassergekühlte wärmeableitende Vorrichtung und ein Wärmeerzeugungsmodul (3), das an der wassergekühlten wärmeableitenden Vorrichtung angeordnet ist, wobei die wassergekühlte wärmeableitende Vorrichtung die wassergekühlte wärmeableitende Vorrichtung nach einem der Ansprüche 1 bis 16 ist.

18. Elektrische Vorrichtung nach Anspruch 17, wobei die elektrische Vorrichtung eine elektrische Fahrzeugsteuerung ist.

## Revendications

1. Dispositif de dissipation thermique refroidi par eau, comprenant une première plaque refroidie par eau (1) et une plaque d'étanchéité (2) ; dans lequel
la première plaque refroidie par eau (1) comprend un premier substrat refroidi par eau (1-1) et une pluralité de premières ailettes de dissipation thermique (1-3) disposées sur le premier substrat refroidi par eau (1-1) ; et
la plaque d'étanchéité (2) comprend un substrat de plaque d'étanchéité (2-1) et une pluralité de secondes ailettes de dissipation thermique (2-2) disposées sur le substrat de plaque d'étanchéité (2-1) et chacune étant disposée entre deux de la pluralité de premières ailettes de dissipation thermique (1-3), et le premier substrat refroidi par eau (1-1) est hermétiquement adapté au substrat de plaque d'étanchéité (2-2) pour former une cavité refroidie par eau (1-2) pour loger la pluralité de premières ailettes de dissipation thermique (1-3) et la pluralité de secondes ailettes de dissipation thermique (2-2) ; **caractérisé en ce que**,
le dispositif de dissipation thermique refroidi par eau comprend en outre un premier composant thermoconducteur avec une extrémité reliée au premier substrat refroidi par eau (1-1) et l'autre extrémité reliée aux secondes ailettes de dissipation thermique (2-2).

2. Dispositif de dissipation thermique refroidi par eau selon la revendication 1, dans lequel le premier composant thermoconducteur comprend un premier élément de compression élastique (4), une première extrémité du premier élément de compression élastique (4) est reliée au premier substrat refroidi par eau (1-1), et une seconde extrémité du premier élément de compression élastique (4) est reliée aux extrémités libres des secondes ailettes de dissipation thermique (2-2).

3. Dispositif de dissipation thermique refroidi par eau selon la revendication 2, dans lequel le premier composant thermoconducteur comprend une première plaque thermoconductrice reliée à la seconde extrémité du premier élément de compression élastique (4), et le premier élément de compression élastique (4) vient en butée contre les secondes ailettes de dissipation thermique (2-2) à travers la première plaque thermoconductrice.

4. Dispositif de dissipation thermique refroidi par eau selon la revendication 2, dans lequel le premier élément de compression élastique (4) est un ressort, et la seconde extrémité du premier élément de compression élastique (4) est un plan thermoconducteur qui vient en butée contre les premières ailettes de dissipation thermique (1-3).

5. Dispositif de dissipation thermique refroidi par eau selon la revendication 2, dans lequel une pluralité de premiers éléments de compression élastiques (4) sont disposés entre deux premières ailettes de dissipation thermique adjacentes (1-3).

6. Dispositif de dissipation thermique refroidi par eau selon la revendication 1, dans lequel le premier composant thermoconducteur est une première colle thermoconductrice (5) remplie au fond d'une rainure des deux premières ailettes de dissipation thermique adjacentes (1-3).

7. Dispositif de dissipation thermique refroidi par eau selon la revendication 1, dans lequel la plaque d'étanchéité (2) est une seconde plaque refroidie par eau, et le dispositif de dissipation thermique refroidi par eau comprend un second composant thermoconducteur avec une extrémité reliée aux premières ailettes de dissipation thermique (1-3) et l'autre extrémité reliée au substrat de plaque d'étanchéité (2-1).

8. Dispositif de dissipation thermique refroidi par eau selon la revendication 7, dans lequel le second composant thermoconducteur comprend un second élément de compression élastique (7), une première extrémité du second élément de compression élastique (7) est reliée au substrat de plaque d'étanchéité (2-1), et une seconde extrémité du second élément de compression élastique (7) est reliée aux extrémités libres des premières ailettes de dissipation thermique (1-3).

9. Dispositif de dissipation thermique refroidi par eau selon la revendication 8, dans lequel le second composant thermoconducteur comprend une seconde plaque thermoconductrice reliée à la seconde extrémité du second élément de compression élastique (7), et le second élément de compression élastique (7) vient en butée contre les premières ailettes de dissipation thermique (1-3) à travers la seconde plaque thermoconductrice.

10. Dispositif de dissipation thermique refroidi par eau selon la revendication 9, dans lequel le second élément de compression élastique (7) est un ressort, et la seconde extrémité du second élément de compression élastique (7) est un plan thermoconducteur qui vient en butée contre les premières ailettes de dissipation thermique (1-3).

11. Dispositif de dissipation thermique refroidi par eau selon la revendication 8, dans lequel une pluralité de seconds éléments de compression élastique (7) sont disposés entre deux secondes ailettes de dissipation thermique adjacentes.

12. Dispositif de dissipation thermique refroidi par eau selon la revendication 7, **caractérisé en ce que** le second composant thermoconducteur est une seconde colle thermoconductrice (6) remplie en fond de rainure des deux secondes ailettes de dissipation thermique adjacentes (2-2).

13. Dispositif de dissipation thermique refroidi par eau selon la revendication 1, dans lequel l'espacement entre les deux premières ailettes de dissipation thermique adjacentes (1-3) est égal à l'espacement entre les deux secondes ailettes de dissipation thermique adjacentes (2-2).

14. Dispositif de dissipation thermique refroidi par eau selon la revendication 1, dans lequel la pluralité de premières ailettes de dissipation thermique (1-3) et la pluralité de seconds ailettes de dissipation thermique (2-2) sont disposées alternativement en séquence.

15. Dispositif de dissipation thermique refroidi par eau selon l'une quelconque des revendications 1 à 14, dans lequel la première plaque refroidie par eau (1) et/ou la plaque d'étanchéité (2) a/ont une structure formée d'un seul tenant.

16. Dispositif de dissipation thermique refroidi par eau selon la revendication 15, dans lequel la première plaque refroidie par eau (1) et/ou la plaque d'étanchéité (2) a/ont une structure de moulage sous pression.

17. Dispositif électrique, comprenant un dispositif de dissipation thermique refroidi par eau et un module de génération thermique (3) disposé sur le dispositif de dissipation thermique refroidi par eau, dans lequel le dispositif de dissipation thermique refroidi par eau est le dispositif de dissipation thermique refroidi par eau selon l'une quelconque des revendications 1 à 16.

18. Dispositif électrique selon la revendication 17, dans lequel le dispositif électrique est un contrôleur de véhicule électrique.
